# EUROPÄISCHE PATENTSCHRIFT

(11) **EP 0 826 256 B1**
(45) Veröffentlichungstag und Bekanntmachung des Hinweises auf die Patenterteilung: **17.03.1999**
(21) Anmeldenummer: 96913468.3
(22) Anmeldetag: 03.05.1996
(51) Int. Cl.: H01S 3/085, H01S 3/025, H01S 3/19, G02B 6/42, H01L 31/12

(54) **VERFAHREN ZUR HERSTELLUNG EINER DFB-LASERDIODE MIT ANGEKOPPELTEM WELLENLEITER UND DFB-LASERDIODENSCHICHTSTRUKTUR**
PROCESS FOR PRODUCING A DFB LASER DIODE WITH COUPLED WAVEGUIDE AND DFB LASER DIODE LAYER STRUCTURE
PROCEDE DE PRODUCTION D'UNE DIODE LASER A REACTION DISTRIBUEE (DFB) A GUIDE D'ONDES ACCOUPLE ET STRUCTURE DE COUCHES D'UNE DIODE LASER A REACTION DISTRIBUEE

(30) Priorität: 18.05.1995 DE 19518350
(43) Veröffentlichungstag der Anmeldung: 04.03.1998
(73) Patentinhaber: SIEMENS AKTIENGESELLSCHAFT, 80333 München (DE)
(72) Erfinder: STEGMÜLLER, Bernhard, D-86163 Augsburg (DE); MATZ, Richard, D-83052 Bruckmühl (DE)
(86) Internationale Anmeldenummer: DE9600781
(87) Internationale Veröffentlichungsnummer: WO9637020

(56) Entgegenhaltungen:
- EP-A- 0 454 902
- FR-A- 2 647 276
- ELECTRONICS LETTERS, Bd. 28, Nr. 25, 3.Dezember 1992, Seiten 2361-2362, XP000332649 ZAH C E: "Monolithic integration of multiwavelength compressive-strained multiquantum-well distributed-feedback laser array with star coupler and optical amplifiers"
- ELECTRONICS LETTERS, Bd. 26, Nr. 2, 18.Januar 1990, Seite 142/143 XP000105121 WILLIAMS P J ET AL: "High performance buried ridge DFB lasers monolithically integrated with butt coupled strip loaded passive waveguides for oeic"
- APPLIED PHYSICS LETTERS, Bd. 54, Nr. 2, 9.Januar 1989, Seiten 114-116, XP000115343 LIOU K -Y ET AL: "Monolithic integrated InGaAsP/InP distributed feedback laser with Y-branching waveguide and a monitoring photodetector grown by metalorganic chemical vapor deposition"
- PATENT ABSTRACTS OF JAPAN vol. 009, no. 230 (E-343), 17.September 1985 & JP,A,60 084892 (SUMITOMO DENKI KOGYO KK), 14.Mai 1985,

## Beschreibung

Die Erfindung betrifft ein Verfahren zur Herstellung einer MCRW-DFB-Laserdiode mit angekoppeltem Wellenleiter und eine MCRW-DFB-Laserdiodenschichtstruktur.

Die optische Datenübertragung hat heute im Weitverkehr wesentliche Bedeutung erlangt, im Teilnehmeranschlußbereich ist ihre Verbreitung jedoch aus Kostengründen noch gering. Um dem Netzteilnehmer über seinen Anschluß Zugriff auf distributive und interaktive Dienste und die entsprechenden unidirektionalen und bidirektionalen Datenströme zu geben, enthalten die hier eingesetzten Anschlußmodule als primäre Funktionen den Sender in Form eines Halbleiterlasers und den Empfänger in Form einer Photodiode. Als Sekundärfunktion treten eine Monitordiode zur Überwachung des Sendelasers und ein wellenlängenselektives Filter hinzu, um durch Trennung der unterschiedlichen Sende- und Empfangswellenlängen Nebensprechen zu unterdrücken. Um die nach Systemaspekten zu erwartende Nachfrage nach großen Stückzahlen zu bedienen, sind diese Module kostengünstig herzustellen.

Kommerzielle Sende-Empfangs-Module mit den beschriebenen vier Funktionen Laserdiode, Monitordiode, Empfängerdiode und Filter werden nach dem derzeitigen Stand der Technik in mikrooptischer Bauweise hergestellt (siehe Werbeschrift "BIDI Bidirektionale Module" Nr. B155-H6656-X-X-7400 (1993) der Siemens AG). Dabei führt die Vielzahl der Einzelteile zu relativ lohnintensiven Montage- und Justageschritten. Im Rahmen dieser Technologie bieten sich mehrere Möglichkeiten zur weiteren Kostensenkung, etwa durch Verwendung vorgefertigter Subeinheiten, beispielsweise Faser-Linsen-Einheit, Laser-Monitor-Einheit, u.a. durch Entwicklung rationeller Aufbautechnik unter Steigerung von Qualität, Ausbeute und Lebensdauer der diskreten Modulkomponenten. Als Beispiel sei der Übergang vom MCRW-Laser (MRCW steht für metal clad ridge waveguide) mit homogener laseraktiver Schicht zum MCRW-Laser mit verspannter Quantum-Well-Struktur (SL-MQW-Struktur, SL-MQW steht für strained layer multiple quantum well). Dieser Laser bietet neben den bekannten Vorteilen der MCRW-Struktur, die in einfacher Epitaxie, geringem Leckstrom und hoher Lebensdauer liegen, zusätzlich geringe Schwelle und hohe maximale Betriebstemperatur, so daß ein Hochtemperaturlaser gegeben ist. Die Charakteristika eines MCRW-Lasers für 1,3 µm sind im einzelnen in B. Stegmüller, E. Veuhoff, J. Rieger und H. Hedrich "High-temperature (130°C) CW operation of 1,53 µm InGaAsP ridge-waveguide lasers using strained quaternary quantum wells", Electronics Letter, Vol. 29 (1993), No. 19, S. 1691-1693, beschrieben.

In der älteren deutschen Patentanmeldung P 44 04 756.8 (GR 94 P 1081 DE) ist die monolithische Integration der vier Funktionen auf einem Substrat aus Halbleitermaterial, beispielsweise InP, vorgeschlagen. Hierfür werden Planartechnologien eingesetzt, wie sie sich für die Herstellung von Siliziumchips bewährt haben. Die photonische Integration auf InP macht dabei im einzelnen von Technologien Gebrauch, die für diskrete InP-Bauelemente heute weitgehend Stand der Technik sind. Dazu gehören Epitaxie, Lithographie, Ätztechnik usw.. Justagevorgänge zwischen mikrooptischen Teilen werden durch photolithographisch definierte Bauelementstrukturen ersetzt. Die Vereinheitlichung der Technologie führt zu gleichartigen, austauschbaren Anlagen und Prozeßschritten. Die durch monolithische Integration verminderte Teilezahl im Modul reduziert Montagezeiten und erhöht die Robustheit. Ein Verfahren zur Herstellung einer DFB-Laserdiode (DFB steht für "distributed feedback" = verteilte Rückkopplung) und eine nach diesem Verfahren hergestellte DFB-Laserdiodenschichtstruktur sind in diesem Dokument konkret vorgeschlagen.

Aus der EP-A-0 454 902 geht ein monolithisch integrierter Schaltkreis, der u.a. eine MCRW-DFB-Laserdiodenstruktur mit stoßgekoppeltem Wellenleiter aufweist, sowie ein 4-Schritt-Epitaxie-Verfahren zu dessen Herstellung hervor. Die Laserdiode weist eine massive quaternäre aktive Schicht auf. Die DFB-Gitterstruktur ist unterhalb der aktiven Schicht angeordnet.

Aus Electronics Letters 28 (1992), Seite 2361 geht eine kompressiv verspannte MQW-DFB-Laserdiode mit einem monolithisch integrierten Wellenleiter, der durchgehend ist, sowie eine oberhalb der aktiven Schicht angeordnete Gitterstruktur, die zweischichtig ist, hervor.

Durch das im Anspruch 1 angegebene erfindungsgemäße Verfahren kann vorteilhafterweise eine monolithisch integrierte MCRW-DFB-Hochtemperaturlaserdiode mit angekoppeltem Wellenleiter hergestellt werden, wobei überdies der Vorteil besteht, daß für Module mit Sendefunktion, also insbesondere auch bidirektionale Module durch das erfindungsgemäße Verfahren die Performance- und Kostenvorteile dieses Lasertyps mit Vorteilen der monolithischen Integration verknüpft werden.

Es ist außerdem ein Vorzug des erfindungsgemäßen Verfahrens, daß von den vier Epitaxien die erste und zweite und die dritte und vierte jeweils unmittelbar nacheinander ausgeführt werden und daß nur durch die Gitterherstellung eine Unterbrechung auftritt. Da das Substrat nur kurz für einen Ätzschritt, beispielsweise in einem HF-Bad, aus der Epitaxieanlage genommen werden muß, liegt praktisch eine einzige Epitaxie vor. Außerdem besteht der Vorteil, daß ähnlich wie bei dem Verfahren nach der oben näher bezeichneten älteren Patentanmeldung zusätzlich eine ternäre Empfänger-Photodiode auf dem Wellenleiter integriert werden kann. Die zugehörigen Bauelementschichten können ähnlich wie bei der älteren Patentanmeldung bei dem Epitaxieschritt zur Herstellung des Wellenleiters aufgewachsen, strukturiert und bei dem nachfolgenden Epitaxieschritt, der in diesem Fall selektiv auszuführen ist, bis zur ebenen Oberfläche überwachsen werden. Alle weiteren Verfahrensschritte sind mit denen der Version ohne Empfänger-Photodiode identisch.

Bevorzugte und vorteilhafte Ausgestaltungen des erfindungsgemäßen Verfahrens gehen aus den Ansprüchen 2 bis 6 hervor.

Eine durch das erfindungsgemäße Verfahren bedingte neue MCRW-DFB-Laserdiodenschichtstruktur ist im Anspruch 7 angegeben. Bevorzugte und vorteilhafte Ausgestaltungen dieser Laserdiodenschichtstruktur gehen aus den Ansprüchen 8 bis 12 hervor.

Die Erfindung wird in der nachfolgenden Beschreibung anhand der Figuren beispielhaft näher erläutert. Es zeigen:
- Figur 1: einen längsaxialen Schnitt durch eine erfindungsgemäße DFB-Laserdiode und einen daran angekoppelten optischen Wellenleiter, wobei dieser Schnitt einem Schnitt längs der Schnittlinie I - I in Figur 2 entspricht,
- Figur 2: einen längs der Schnittlinie II - II in Figur 1 genommenen Querschnitt durch diese DFB-Laserdiode,
- Figur 3: einen längs der Schnittlinie III - III in Figur 1 genommenen Querschnitt durch den strukturierten Wellenleiter,
- Figur 4: in vergrößerter Darstellung den in Figur 1 mit A bezeichneten Ausschnitt aus der laseraktiven Schicht der erfindungsgemäßen Laserdiode zur deutlicheren Sichtbarmachung der Quantum-Well-Schichten und Barriereschichten,
- Figur 5: in perspektivischer Darstellung die Ausführung einer nach dem erfindungsgemäßen Verfahren hergestellten kompletten Anordnung aus einer DFB-Laserdiode mit angekoppelten Wellenleiter,
- Figur 6: in vergrößerter Darstellung den in der Figur 5 mit B bezeichneten Ausschnitt zur deutlicheren Darstellung der Koppelstelle, bei welcher die Laserdiode und der Wellenleiter aneinandergekoppelt sind,
- Figur 7: in stark vereinfachter schematische Darstellung einen erste Chipform aus Laserdioden mit angekoppelten Wellenleitern und Photodioden und
- Figur 8: in stark vereinfachter schematische Darstellung einen zweite Chipform aus Laserdioden mit angekoppelten Wellenleitern und Photodioden und

Die Figuren sind schematisch und nicht maßstäblich.

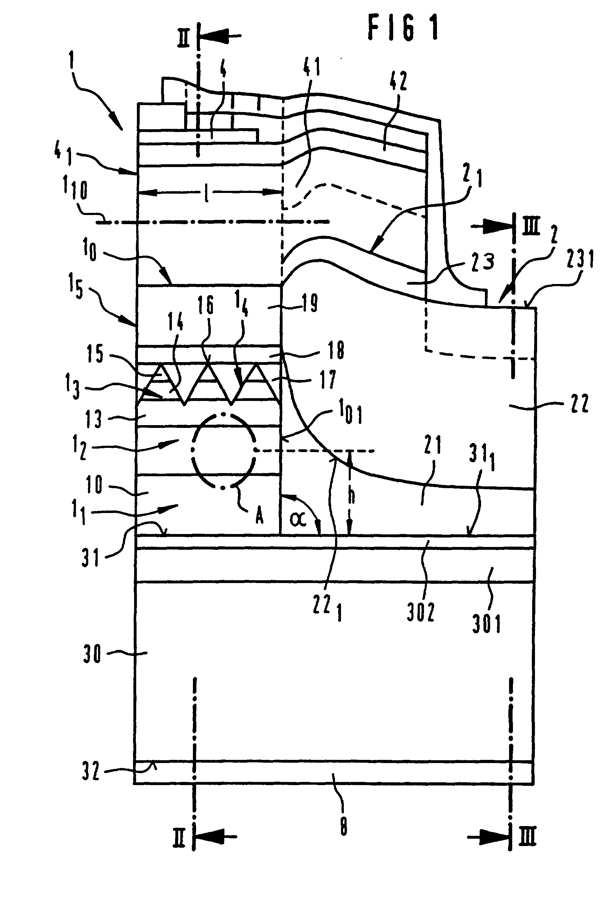

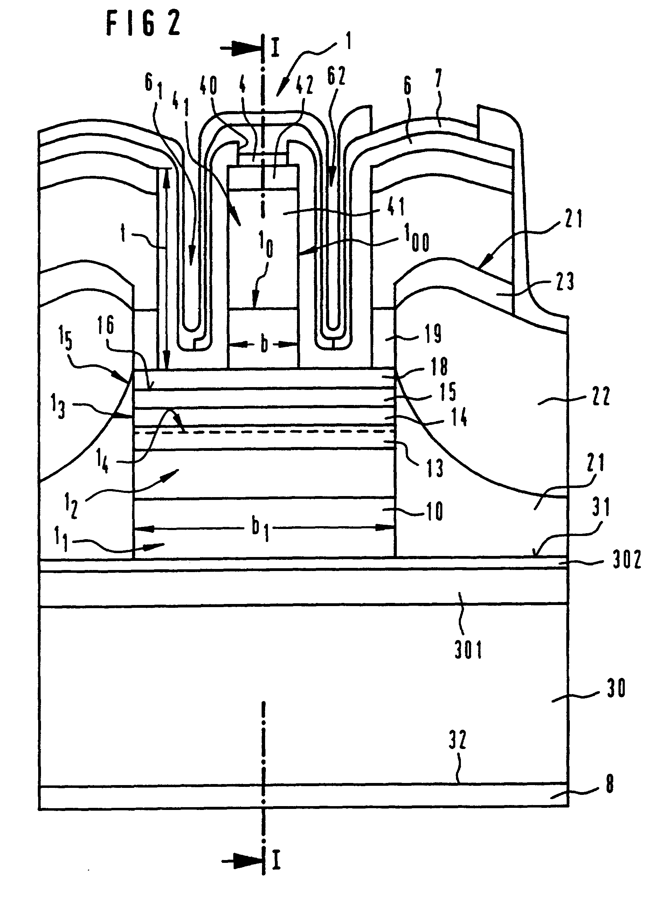

Das erfindungsgemäße Verfahren wird zunächst anhand der Figuren 1 bis 3 beschrieben.

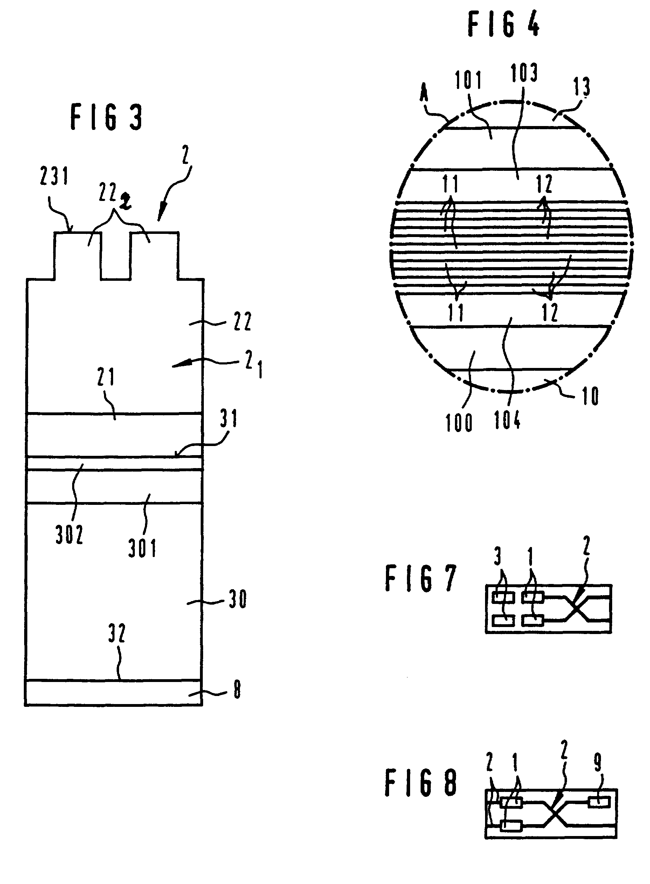

Auf der Oberfläche 31 eines Substrats 30 aus Halbleitermaterial eines bestimmten Leitfahigkeitstyps, beispielsweise n-dotiertes Halbleitermaterial, wird in einem ersten Epitaxieschritt
ein aus zumindest einer Schicht 10 aus Halbleitermaterial des bestimmten Leitfähigkeitstyps n bestehender erster Schichtenstapel 1₁,
auf diesem ersten Schichtenstapel 1₁ eine aus zwei oder mehreren kompressiv verspannten Quantum-Well-Schichten 11 (siehe Figur 4) aus einem quaternären Material und aus einer oder mehreren zwischen den Quantum-Well-Schichten 11 liegenden Barriereschichten 12 aus einem quaternärem Material bestehende laseraktive Schicht 1₂ und
auf dieser laseraktiven Schicht 1₂ ein aus zwei oder mehreren Schichten 13, 14, 15 aus Halbleitermaterial des zum bestimmten Leitfähigkeitstyp n entgegengesetzten Leitfähigkeitstyps p bestehender zweiter Schichtenstapel 1₃ mit einer von der laseraktiven Schicht 1₂ abgekehrten Oberfläche 16 erzeugt.

In der Oberfläche 16 des zweiten Schichtenstapels 1₃ wird ein optisches Gitter 1₄ in Form eines Reliefs erzeugt, beispielsweise ein Gitter 1₄ aus parallel verlaufenden Gitterfurchen mit jeweils dreieckförmigem Profil, deren Längsachse in der Figur 1 senkrecht zur Zeichenebene steht.

In einem zweiten Epitaxieschritt wird auf der Oberfläche 16 des zweiten Schichtenstapels 1₃ ein aus einer oder mehreren Schichten 17, 18, 19 aus Halbleitermaterial des entgegengesetzten Leitfähigkeitstyps p bestehender und das Gitter 1₄ abdeckender dritter Schichtenstapel 1₅ erzeugt.

Der zweite Schichtenstapel 1₃, die laseraktive Schicht 1₂ und der erste Schichtenstapel 1₁ werden bereichsweise bis zur Oberfläche 31 des Substrats 30 entfernt, so daß auf dieser Oberfläche 31 ein aus dem ersten Schichtenstapel 1₁, der laseraktiven Schicht 1₂ und dem zweiten Schichtenstapel 1₃ bestehender erhabener Bereich 1₀ mit einer in einem vorzugsweise etwa 90° betragenden Winkel α zur Oberfläche 31 des Substrats 30 stehenden Stirnfläche 1₀₁ stehenbleibt und neben diesem erhabenen Bereich 1₀ ein an dessen Stirnfläche 1₀₁ grenzender Bereich 31₁ der Oberfläche 31 des Substrats 30 freiliegt.

In einem dritten Epitaxieschritt wird auf dem freiliegenden Bereich 31₁ der Oberfläche 31 des Substrats 30, nicht aber auf dem erhabenen Bereichen 1₀, ein den Wellenleiter 2 definierender vierter Schichtenstapel 2₁ erzeugt, der aus einer ersten und zweiten optischen Mantelschicht 21, 23 sowie einer zwischen diesen Mantelschichten 21, 23 liegenden wellenleitenden Schicht 22 besteht, wobei die wellenleitende Schicht 22 in Bezug auf die Oberfläche 31 des Substrats 30 in Höhe h der laseraktiven Schicht 1₂ liegt und eine der Stirnfläche 1₀₁ des erhabenen Bereichs 1₀ gegenüberliegende Stirnfläche 22₁ aufweist.

In einem vierten Epitaxieschritt wird auf dem erhabenen Bereich 1₀ und dem vierten Schichtenstapel 2₁ ein aus zumindest einer Schicht 41 aus Halbleitermaterial des entgegengesetzten Leitfähigkeitstyps p und einer Kontaktschicht 42 zum Aufbringen eines vorzugsweise metallischen elektrischen Kontaktes 4 bestehender fünfter Schichtenstapel 4₁ erzeugt.

Dies sind die wesentlichen Verfahrensschritte des erfindungsgemäßen Verfahrens zur Herstellung einer DFB-Laserdiode und eines optisch an die Laserdiode gekoppelten optischen Wellenleiters.

Vorteilhafterweise werden im stehengebliebenen erhabenen Bereich 1₀ zwei bis in die Nähe des Gitters 1₄ sich in die Tiefe t erstreckende Vertiefungen 61, 62 erzeugt, die durch eine Rippe 1₀₀ aus zwischen den Vertiefungen 61, 62 über dem Gitter 1₄ stehengebliebenen Schichten 19, 41, 42 des erhabenen Bereichs 1₀ und mit einer zur Stirnfläche 1₀₁ des erhabenen Bereichs 1₀ im wesentlichen senkrechten Längsachse 1₁₀ voneinander getrennt sind und sich bis in die Nähe dieser Stirnfläche 1₀₁ erstrecken. Die Breite b der Rippe 1₀₀ definiert die Breite der Laserdiode, d.h. den Bereich, in welchem in der laseraktiven Schicht 1₂ das Laserlicht erzeugt und aus dieser Schicht 1₂ durch die Stirnfläche 1₀₁ des erhabenen Bereichs 1₀ in den Wellenleiter 2 abgestrahlt wird.

Der an die Stirnfläche 1₀₁ des erhabenen Bereichs 1₀ optisch angekoppelte Wellenleiter 2 ist ein Schichtwellenleiter. Zur Erzeugung optischer Richtkopplern und anderer Wellenleiterstrukturen, beispielsweise Filter, Modulatoren, Schalter oder dergl., die streifenartige Wellenleiter benötigen, werden vorteilhafterweise nach dem vierten Epitaxieschritt im vierten Schichtenstapel 2₁ die über der wellenleitenden Schicht 22 des Wellenleiters 2 befindlichen Schichten 23, 41, 42 entfernt und in der freigelegten Oberfläche 231 dieser wellenleitenden Schicht 22 eine Struktur aus Rippen 22₂ erzeugt, wobei jede Rippe 22₂ einen Rippenwellenleiter definiert, der ein streifenartiger Wellenleiter ist. Zwei streckenweise parallel verlaufende Rippen 22₂ können beispielsweise einen optischen Richtkoppler definieren.

Beim selektiven dritten Epitaxieschritt wird zweckmäßigerweise so vorgegangen, daß der erhabene Bereich 1₀ mit einer dessen Stirnfläche 1₀₁ freilassenden, nicht dargestellten passivierenden Schicht abgedeckt wird, auf der beim dritten Epitaxieschritt kein Material aufwächst. Nach dem dritten Epitaxieschritt und vor dem vierten Epitaxieschritt wird die passivierende Schicht entfernt.

Die laseraktive Schicht 1₂ weist zwei oder mehrere, vorzugsweise bis zu acht kompressiv verspannte und Quantentöpfe definierende Quantum-Well-Schichten 11 aus quaternärem Material mit dazwischenliegenden Barriereschichten aus quaternärem Material auf (siehe B. Stegmüller, E. Veuhoff, J. Rieger und H. Hedrich "High-temperature (130°C) CW operation of 1,53 µm InGaAsP ridge-waveguide lasers using strained quaternary quantum wells", Electronics Letter, Vol. 29 (1993), No. 19, S. 1691-1693). Zur Erzielung hoher optischer Leistung im Bereich dieser laseraktiven Schicht sind die Quantum-Well-Schichten 11 und Barriereschichten 12 zwischen zwei Schichten 100, 101 aus einem quaternärem Material mit einer im Vergleich zu den Quantum-Well-Schichten 11 niedrigeren Gap-Wellenlänge angeordnet. Beim Beispiel nach Figur 4 befindet sich zwischen den Quantum-Well- und Barriereschichten 11 und 12 und jeder Schicht 100 und 101 mit niedrigerer Gap-Wellenlänge je eine Schicht 102 bzw. 103 aus quaternärem Material mit der gleichen Gap-Wellenlänge wie die Quantum-Well-Schichten 11.

Die Vertiefungen 61, 62, welche die Rippe 1₀₀ definieren und in ihrer Breite und Länge vollständig innerhalb des erhabenen Bereichs 1₀ liegen, können mit hoher Genauigkeit hergestellt werden, wenn im zweiten Epitaxieschritt ein dritter Schichtenstapel 1₅ erzeugt wird, der eine das Gitter 1₄ abdeckende Ätzstoppschicht 18 aufweist. Diese Ätzstoppschicht 18 muß aus einem Material sein, welches von einem Ätzmittel, das die über dieser Ätzstoppschicht 18 liegende Schicht 19angreift, nicht oder schwächer angegriffen wird.

Die Rippe 1₀₀ und benachbarte Bereiche werden mit einem Isolationsdielektrikum 6 abgedeckt, in welchem auf der Rippe 1₀₀ ein Kontakt fenster 40 geöffnet wird. In diesem Kontaktfenster 40 wird der Kontakt 4 auf die Kontaktschicht 42 aufgebracht, der mit Kontaktleitungen 7 verbunden wird.

Zweckmäßig ist es, in der Kontaktschicht 42 und/oder der darunterliegenden Schicht 41 die Leitfähigkeit zu erhöhen, beispielsweise durch Erhöhung der dortigen Dotierung mit einem geeigneten Dotierstoff.

Zweckmäßig ist es auch, wenn ein Substrat 30 verwendet wird, dessen Oberfläche 31 durch eine auf einer Pufferschicht 301 des Substrats 30 aufgebrachte Ätzstoppschicht 302 definiert ist. Das Material dieser Ätzsstoppschicht 302 ist so zu wählen, daß es von einem die darüberliegende Schicht 10 angreifenden Ätzmittel nicht oder weniger angegriffen wird.

Die von der Oberfläche 31 abgekehrte rückseitige Oberfläche 32 des Substrats 30 wird mit einem Rückseitenkontakt 8 versehen.

Bei dem bisher beschriebenen Beispiel entspricht der bestimmte eine Leitfähigkeitstyp einer n-Dotierung und der entgegengesetzte Leitfähigkeitstyp einer p-Dotierung. Es könnte auch umgekehrt sein.

Bei einer konkreten Realisierung des Ausführungsbeispiels, die eine MCRW-DFB-Hochtemperaturlaserdiode 1 mit angekoppeltem Wellenleiter 2 bildet, besteht das Substrat 30 aus n⁺-dotiertem InP, die Pufferschicht 301 besteht aus n-dotiertem InP und ist 1,5 µm dick, die Ätzstoppschicht 302 besteht aus n-dotiertem quaternärem InGaAsP mit einer Gap-Wellenlänge von 1,05 µm und einer Dicke nur 0,05 µm. Der erste Schichtenstapel 1₁ besteht aus einer einzelnen Schicht 10 aus n-dotiertem InP und einer Dicke von 0,4 µm.

Die laseraktive Schicht 1₂ weist beispielsweise fünf Quantum-Well-Schichten 11 aus quaternärem Material mit einer Gap-Wellenlänge von 1,1 µm auf, die durch Barriereschichten 12 aus quaternärem Material mit einer Gap-Wellenlänge von 1,25 µm voneinander getrennt sind. Die Schichten 103 und 104 bestehen aus quaternärem Material mit einer Gap-Wellenlänge von 1,1 mm und die Schichten 100 und 101 bestehen aus quaternärem Material mit einer Gap-Wellenlange von 1,05 µm. Die Schichten 101 und 102 bilden ebenso wie die Schichten 101 und 103 jeweils zusammen sog. Separat Confinement-Heterostructure-Schichten (SCH-Schichten). Die Dicke der laseraktiven Schicht 1₂ beträgt insgesamt etwa 0,28 µm.

Der zweite Schichtenstapel 1₃ besteht aus einer unmittelbar auf der laseraktiven Schicht 1₂ aufgebrachten p-dotierten Schicht aus InP, einer auf dieser Schicht 13 aufgebrachten p-dotierten Schicht 14 aus quaternärem Material mit einer Gap-Wellenlänge von 1,05 µm und einer auf dieser Schicht 14 aufgebrachten p-dotiertem Schicht 15 aus InP oder InGaAs. Anstelle von drei Schichten könnten auch vier Schichten verwendet werden. Die von der Schicht 15 abgedeckte Schicht 14 aus dem quaternären Material hat den Vorteil, daß das in diesem zweiten Schichtenstapel 1₃ erzeugte optische Gitter 1₄ eine von der Ätztiefe der Gitterfurchen unabhängige Koppelkonstante aufweist.

Der beim zweiten Epitaxieschritt erzeugte dritte Schichtenstapel 1₅ besteht aus der unmittelbar auf dem Gitter 1₄ aufgebrachten p-dotierten Schicht 17 aus InP, aus der auf dieser Schicht 17 aufgebrachten p-dotierten Ätzstopschichtschicht 18 aus quaternärem Material mit einer Gap-Wellenlänge von 1,05 µm und einer auf dieser Schicht 18 aufgebrachten p-dotierten Schicht 19 aus InP.

Durch kombinierte Trocken- und Naßätzung wird anschließend der erhabene Bereich 1₀ mit einer Breite b₁ von etwa 20 µm und einer bis zu dessen Stirnfläche 1₀₁ reichenden Länge 1 von etwa 400 µm bis zur Ätzstopschichtschicht 302 geätzt.

Die bei der Herstellung des Wellenleiters 2 verwendete passivierende Schicht besteht aus SiO₂. Die beiden Mantelschichten 21 und 23 des Wellenleiters 2 bestehen aus InP und die wellenleitende Schicht 22 besteht aus quaternärem Material mit einer Gap-Wellenlänge von 1,05 µm. Die Dicke der wellenleitenden Schicht 22 beträgt beispielsweise etwa 0,64 µm, die in seiner Oberfläche 231 ausgebildeten Rippen 22₁ haben eine Höhe von 0,2 µm und eine Breite von 1,3 µm.

Der bei der vierten ganzflächigen Epitaxie erzeugte fünfte Schichtenstapel 4₁ besteht aus einer auf den dritten Schichtenstapel 1₅ und den vierten Schichtenstapel 2₁ aufgebrachten p-dotierten Schicht 41 aus InP und aus der auf dieser Schicht 41 aufgebrachten Kontaktschicht 42 aus p-dotiertem InGaAs. Zu einer Erhöhung der p-Dotierung in diesen Schichten 41 und 42 im kann Zn verwendet werden.

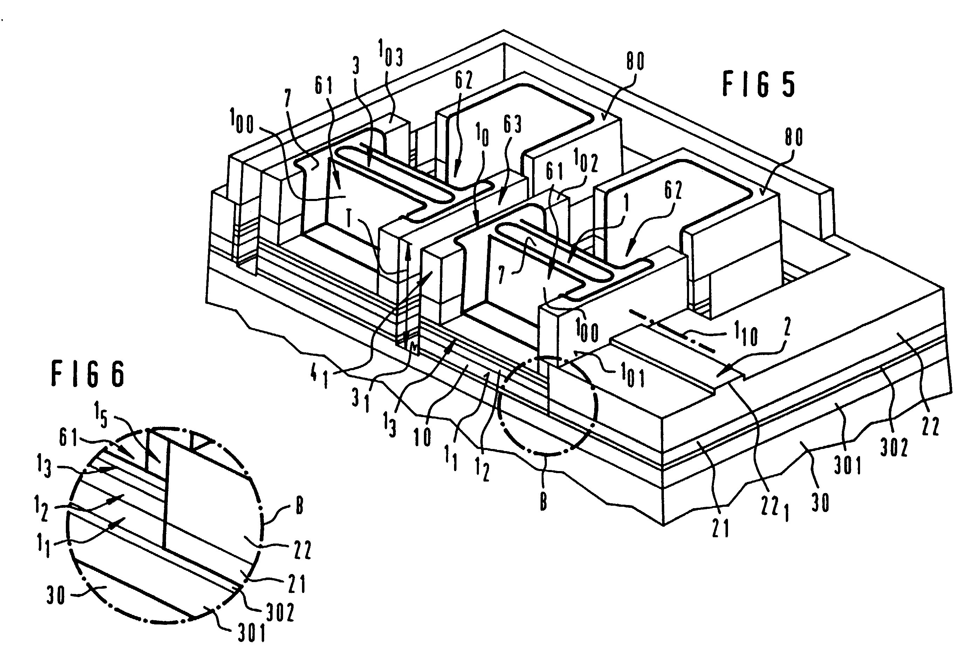

Die Anordnung nach Figur 5 ist eine nach dem erfindungsgemäßen Verfahren hergestellte integrierte MCRW-Laserdiode 1 mit angekoppeltem Wellenleiter 2, wie sie vorstehend im Zusammenhang mit den Figuren 1 bis 4 ausführlich beschrieben worden sind. Diese Anordnung weist zusätzlich eine Monitordiode 3 auf, welche die gleiche Struktur wie die Laserdiode 1 aufweist. Die Laserdiode 1 und die Monitordiode 3 sind dadurch entstanden, daß im stehengebliebenen erhabenen Bereich 1₀ ein sich im wesentlichen parallel zu dessen Stirnfläche 1₀₁ und bis zur Oberfläche 31 des Substrats 30 in die Tiefe T erstreckender Trenngraben 63 erzeugt wird, der den erhabenen Bereich 1₀ in Zwei voneinander getrennte Teile 1₀₂ und 1₀₃ unterteilt. Der Teil 1₀₂ definiert die Laserdiode 1 und der Teil 1₀₃ die Monitordiode 3.

Die aus der Ätzung der beiden Vertiefungen 61 und 62 rechts und links neben der von einer elektrischen Leitung 7 abgedeckten jeweiligen Rippe 1₀₀ resultierende Doppel-T-Form der Laserdiode 1 und Monitordiode 3 und ihre elektrische Entkopplung durch den tiefen Trenngraben 63 sind deutlich erkennbar.

Die Ätzung zur Herstellung dieses Trenngrabens 63 dient gleichzeitig zur Formung freistehender Blöcke 80 für Bondpads, wodurch die elektrisch angeschlossenen pn-Flächen und die Leckströme verkleinert werden.

Die Figur 7 zeigt eine Anordnung, bei welcher zwei Laserdioden 1 mit jeweils angekoppelter Monitordiode 3 an einen optischen Richtkoppler aus Rippenwellenleitern 2 angekoppelt ist.

Die Figur 8 zeigt eine Anordnung, bei welcher an zwei Laserdioden 1 auf einer Seite zwei Rippenwellenleiter 2 und auf der anderen Seite ein Richtkoppler aus Rippenwellenleitern 2 angekoppelt sind, wobei ein Zweig des Richtkopplers zu einer separaten Monitordiode 9 führt.

## Patentansprüche

1. Verfahren zur Herstellung einer Anordnung aus einer MCRW-DFB-Hochtemperaturlaserdiode (1) und einem optisch an die Laserdiode (1) gekoppelten optischen Wellenleiter (2), bei dem
auf der Oberfläche eines Substrats (30) aus n⁺-dotiertem InP in einem ersten Epitaxieschritt
- eine Pufferschicht (301) aus n-dotiertem InP, auf dieser
- eine erste Ätzstoppschicht (302) aus quaternärem Material, auf dieser
- ein erster Schichtenstapel (1₁), der zumindest aus einer Schicht (10) aus n-dotiertem InP besteht,
- auf dem ersten Schichtenstapel (1₁) eine laseraktive Schicht (1₂), die aus zwei oder mehreren kompressiv verspannten Quantum-Well-Schichten (11) aus einem quaternären Material und aus einer oder mehreren zwischen den Quantum-Well-Schichten (11) liegenden Barriereschichten (12) aus einem quaternären Material besteht und
- auf der laseraktiven Schicht (1₂) ein zweiter Schichtenstapel (1₃) erzeugt wird, der zumindest aus einer auf der laseraktiven Schicht (1₁) angeordneten Schicht (13) aus p-dotiertem InP, einer auf dieser Schicht (13) angeordneten Schicht (14) aus p-dotiertem quaternären Material und einer auf dieser Schicht (14) angeordneten Schicht (15) aus p-dotiertem InP besteht und eine von der laseraktiven Schicht (1₂) abgekehrte Oberfläche (16) aufweist,
erzeugt werden, wobei
- in der Oberfläche (16) des zweiten Schichtenstapels (1₃) ein optisches Gitter (1₄) in Form eines Reliefs erzeugt wird, wobei in einem zweiten Epitaxieschritt
- auf der das Gitter (1₄) enthaltenden Oberfläche (16) des zweiten Schichtenstapels (1₃) ein dritter Schichtenstapel (1₅) erzeugt wird, der aus einer das Gitter (1₄) bedeckenden Schicht (17) aus p-dotiertem InP oder ternärem Material, einer auf dieser Schicht (17) angeordneten zweiten Ätzstoppschicht (18) aus p-dotiertem quaternärem Material und einer auf dieser Schicht (18) angeordneten Schicht (19) aus p-dotiertem InP besteht, wobei
- der zweite Schichtenstapel (1₃), die laseraktive Schicht (1₂) und der erste Schichtenstapel (1₁) bereichsweise bis zur ersten Ätzstoppschicht (302) entfernt werden, so daß auf dieser Ätzstoppschicht (302) ein aus dem ersten Schichtenstapel (1₁), der laseraktiven Schicht (1₂) und dem zweiten Schichtenstapel (1₃) bestehender erhabener Bereich (1₀) mit einer in einem Winkel (α) zur ersten Ätzstoppschicht (302) stehenden Stirnfläche (1₀₁) stehenbleibt und neben diesem erhabenen Bereich (1₀) ein an dessen Stirnfläche (1₀₁) grenzender Bereich (31₁) der ersten Ätzstoppschicht (302) freiliegt, wobei
in einem dritten Epitaxieschritt
- selektiv auf dem freiliegenden Bereich (31₁) der ersten Ätzstoppschicht (302), nicht aber auf dem erhabenen Bereich (1₀), ein den Wellenleiter (2) definierender vierter Schichtenstapel (2₁) erzeugt wird, der aus einer ersten und zweiten optischen Mantelschicht (21, 23) aus InP sowie einer zwischen diesen Mantelschichten (21, 23) liegenden wellenleitenden Schicht (22) aus quaternärem Material besteht, wobei die wellenleitende Schicht (22) eine in bezug auf die erste Ätzstoppschicht (302) in Höhe (h) der laseraktiven Schicht (1₂) liegt und eine der Stirnfläche (1₀₁) des erhabenen Bereichs (1₀) gegenüberliegende Stirnfläche (22₁) aufweist, und
wobei in einem vierten Epitaxieschritt
- auf dem erhabenen Bereich (1₀) und dem vierten Schichtenstapel (2₁) ein fünfter Schichtenstapel (4₁) erzeugt wird, der aus einer Schicht (41) aus p-dotiertem InP und einer auf dieser Schicht (41) angeordneten Kontaktschicht (42) aus p-dotiertem InGaAs zum Aufbringen eines elektrischen Kontaktes (4) besteht.

2. Verfahren nach Anspruch 1, wobei im stehengebliebenen erhabenen Bereich (1₀) zwei bis zur zweiten Ätzstoppschicht (18) sich in die Tiefe (t) erstreckende Vertiefungen (61, 62) erzeugt werden, die durch eine Rippe (1₀₀), welche aus zwischen den Vertiefungen (61, 62) über der zweiten Ätzstoppschicht (18) stehengebliebenen Schichten (19, 41, 42) des erhabenen Bereichs (1₀) besteht und eine zur Stirnfläche (1₀₁) des erhabenen Bereichs (1₀) im wesentlichen senkrechte LängsAchse (1₁₀) aufweist, voneinander getrennt sind und sich bis in die Nähe dieser Stirnfläche (1₀₁) erstrecken.

3. Verfahren nach Anspruch 1 oder 2, wobei im stehengebliebenen erhabenen Bereich (1₀) ein sich im wesentlichen parallel zu dessen Stirnfläche (1₀₁) und bis zur ersten Ätzstoppschicht in die Tiefe (T) erstreckender Trenngraben (63) erzeugt wird, der den erhabenen Bereich (1₀) in zwei voneinander getrennte Teile (1₀₂, 1₀₃) unterteilt.

4. Verfahren nach einem der vorhergehenden Ansprüche, wobei im vierten Schichtenstapel (2₁) die über der wellenleitenden Schicht (22) befindlichen Schichten (23, 41, 42) entfernt und in der freigelegten Oberfläche (231) der wellenleitenden Schicht (22) zumindest eine Rippe (22₁) erzeugt wird.

5. Verfahren nach einem der vorhergehenden Ansprüche, wobei eine laseraktive Schicht (1₂) erzeugt wird, deren Quantum-Well-Schichten (11) und Barriereschichten (12) zumindest zwischen zwei Schichten (100, 101) aus einem quaternären Material mit einer im Vergleich zur den Quantum-Well-Schichten (11) niedrigeren Gap-Wellenlänge angeordnet sind.

6. Verfahren nach einem der vorhergehenden Ansprüche, wobei auf der laseraktiven Schicht (1₂) ein zweiter Schichtenstapel (1₃) erzeugt wird, bei dem auf der auf der Schicht (14) aus p-dotiertem quaternären Material angeordneten Schicht (15) aus p-dotiertem InP oder ternären Material eine weitere Schicht aus p-dotiertem InP oder ternären Material angeordnet ist, deren von der laseraktiven Schicht (1₂) abgekehrte Oberfläche die Oberfläche (16) des zweiten Schichtenstapels (1₃) bildet.

7. Anordnung aus einer MCRW-DFB-Hochtemperaturlaserdiode (1) und einem optisch an die Laserdiode (1) gekoppelten optischen Wellenleiter (2), wobei auf der Oberfläche eines Substrats (30) aus n⁺-dotiertem InP
- eine Pufferschicht (301) aus n-dotiertem InP und auf der Pufferschicht (301) und
- eine erste Ätzstoppschicht (302) aus n-dotiertem quaternären Material ausgebildet sind,
auf der ersten Ätzstoppschicht (302)
- eine für die Laserdiode (1) vorgesehene erhabene erste Schichtenfolge und eine für den Wellenleiter (2) vorgesehene zweite Schichtenfolge ausgebildet sind, die nebeneineander angeordnet sind, wobei
die erste Schichtenfolge zumindest aus
- einer Schicht (10) aus n-dotiertem InP
- einer auf dieser Schicht (10) angeordneten laseraktiven Schicht (1₂) aus zwei oder mehreren kompressiv verspannten Quantum-Well-Schichten (11) aus einem quaternären Material und aus einer oder mehreren zwischen den Quantum-Well-Schichten (11) liegenden Barriereschichten (12) aus einem quaternären Material,
- einer auf der laseraktiven Schicht (1₂) angeordneten Schicht (13) aus p-dotiertem InP,
- einer auf dieser Schicht (13) angeordneten Schicht (14) aus p-dotiertem quaternären Material,
- einer auf dieser Schicht (14) angeordneten Schicht (15) aus p-dotiertem InP oder ternären Material mit einer von der laseraktiven Schicht (1₂) abgekehrten Oberfläche (16) in der ein optisches Gitter (1₄) in Form eines Reliefs ausgebildet ist,
- einer das Gitter (1₄) bedeckenden Schicht (17) aus p-dotiertem InP,
- einer auf dieser Schicht (17) angeordneten zweiten Ätzstoppschicht (18) aus p-dotiertem quaternärem Material und
- einer auf dieser Schicht (18) angeordneten Schicht (19) aus p-dotiertem InP besteht, und
die zweite Schichtenfolge aus
- einer ersten und zweiten optischen Mantelschicht (21, 23) aus InP sowie
- einer zwischen diesen Mantelschichten (21, 23) liegenden wellenleitenden Schicht (22) aus quaternärem Material besteht, wobei
- die laseraktive Schicht (1₂) und die wellenleitende Schicht (22) in bezug auf die erste Ätzstoppschicht (302) auf gleicher Höhe (h) liegen und in einander gegenüberliegende Stirnflächen (1₀₁, 22₁) aneinandergrenzen, die in einem Winkel (α) zur ersten Ätzstoppschicht (302) stehen, und wobei
- auf den beiden erhabenen Schichtenfolgen ein eine Schicht (41) aus p-dotiertem InP und eine auf dieser Schicht (41) angeordnete Kontaktschicht (42) aus p-dotiertem InGaAs zum Aufbringen eines elektrischen Kontaktes (4) ausgebildet sind.

8. Anordnung nach Anspruch 7, wobei im Bereich der ersten Schichtenfolge zwei bis zur zweiten Ätzstoppschicht (18) sich in die Tiefe (t) erstreckende Vertiefungen (61, 62) ausgebildet sind, die durch eine Rippe (1₀₀), die aus zwischen den Vertiefungen (61, 62) stehengebliebenen Schichten (19, 41, 41) über der zweiten Ätzstoppschicht (18) besteht und eine zur Stirnfläche (1₀₁) der laseraktiven Schicht (1₂) im wesentlichen senkrechte Achse (1₁₀) aufweist, voneinander getrennt sind und sich bis in die Nähe dieser Stirnfläche (1₀₁) erstrecken.

9. Anordnung nach Anspruch 7 oder 8, wobei im Bereich der ersten Schichtenfolge ein sich im wesentlichen parallel zur Stirnfläche (1₀₁) der Laseraktiven Schicht (1₂) und bis zur ersten Ätzstoppschicht in die Tiefe (T) erstreckender Trenngraben (63) erzeugt wird, der die erste Schichtenfolge und die darauf befindlichen übrigen Schichten (41, 42) in zwei voneinander getrennte Teile (1₀₂, 1₀₃) unterteilt.

10. Anordnung nach einem der Ansprüche 7 bis 9, wobei im vierten Schichtenstapel (2₁) die über der wellenleitenden Schicht (22) befindlichen Schichten (23, 41, 42) entfernt und in der freigelegten Oberfläche (231) der wellenleitenden Schicht (22) zumindest eine Rippe (22₁) ausgebildet ist.

11. Anordnung nach einem der Ansprüche 7 bis 10, wobei die Quantum-Well-Schichten (11) und Barriereschichten (12) der laseraktiven Schicht (1₂) zumindest zwischen zwei Schichten (100, 101) aus einem quaternären Material mit einer im Vergleich zur den Quantum-Well-Schichten (11) niedrigeren Gap-Wellenlänge angeordnet sind.

12. Anordnung nach einem der Ansprüche 7 bis 11, wobei in der ersten Schichtenfolge auf der auf der Schicht (14) aus p-dotiertem quaternären Material über der laseraktiven Schicht (1₂) angeordneten Schicht (15) aus p-dotiertem InP oder ternären Material eine weitere Schicht aus p-dotiertem InP oder ternärem Material ausgebildet ist, die eine von der laseraktiven Schicht (1₂) abgekehrte Oberfläche (16) aufweist, in der das optische Gitter (1₄) in Form des Reliefs ausgebildet ist.

## Claims

1. Method for producing an arrangement comprising an MCRW-DFB high-temperature laser diode (1) and an optical waveguide (2) which is optically coupled to the laser diode (1), in which
on the surface of a substrate (30) composed of n⁺-doped InP in a first epitaxial step,
- a buffer layer (301) composed of n-doped InP, on this
- a first etching stop layer (302) composed of a quaternary material, on this
- a first layer stack (1₁) which comprises at least one layer (10), composed of n-doped InP
- on the first layer stack (1₁), a laser-active layer (1₂) which is composed of two or more compressively stressed quantum-well layers (11) composed of a quaternary material and one or more barrier layers (12) located between the quantum-well layers (11) and composed of a quaternary material, and
- on the laser-active layer (1₂), a second layer stack (1₃) is produced, which comprises at least one layer (13) arranged on the laser-active layer (1₁) and composed of p-doped InP, a layer (14) arranged on this layer (13) and composed of p-doped quaternary material, and a layer (15) arranged on this layer (14) and composed of p-doped InP and has a surface (16) facing away from the laser-active layer (1₂),
are produced, in which case:
an optical grating (1₄) is produced in the form of a relief in the surface (16) of the second layer stack (1₃), in which case, in a second epitaxial step,
- a third layer stack (1₅) is produced on the surface (16) of the second layer stack (13) containing the grating (1₄), which third layer stack (1₅) comprises a layer (17) covering the grating (1₄) and is composed of p-doped InP or a ternary material, a second etching stop layer (18) arranged on this layer (17) and composed of p-doped quaternary material, and a layer (19) arranged on this layer (18) and composed of p-doped InP, in which case
- the second layer stack (1₃), the laser-active layer (1₂) and the first layer stack (1₁) are removed in places down to the first etching stop layer (302) so that a raised region (1₀), which comprises the first layer stack (1₁), the laser-active layer (1₂) and the second layer stack (1₃) and having an end surface (1₀₁) at an angle (α) to the first etching stop layer (302), remains on this etching stop layer (302) and a region (31₁), of the first etching stop layer (302), bounding the end surface (1₀₁) of this raised region (1₀) is exposed alongside this raised region (1₀), in which case,
in a third epitaxial step
- a fourth layer stack (2₁) which defines the waveguide (2) is produced selectively on the exposed region (31₁) of the first etching stop layer (302) but not on the raised region (1₀), which fourth layer stack (2₁) comprises a first and a second optical covering layer (21, 23) composed of InP and comprises a wave-conducting layer (22) located between these covering layers (21, 23) and composed of quaternary material, in which case the wave-conducting layer (22) is located at the level (h) of the laser-active layer (1₂) with respect to the first etching stop layer (302) and has an end surface (22₁) which is opposite the end surface (1₀₁) of the raised region (1₀), and
in which case, in a fourth epitaxial step,
- a fifth layer stack (4₁) is produced on the raised region (1₀) and the fourth layer stack (2₁), which fifth layer stack (4₁) comprises a layer (41) composed of p-doped InP and a contact layer (42) arranged on this layer (41) and composed of p-doped InGaAs for the fitting of an electrical contact (4).

2. Method according to Claim 1, in which case two depressions (61, 62) are produced in the remaining raised region (1₀), which depressions (61, 62) extend down to the second etching stop layer (18) in depth (t), are separated from one another by a rib (1₀₀), which comprises layers (19, 41, 42) of the raised region (1₀) which remain over the second etching stop layer (18) between the depressions (61, 62) and has a longitudinal axis (1₁₀) essentially at right angles to the end surface (1₀₁) of the raised region (1₀), and which depressions (61, 62) extend into the vicinity of this end surface (1₀₁).

3. Method according to Claim 1 or 2, in which case an isolating trench (63) is produced in the remaining raised region (1₀), which isolating trench (63) extends essentially parallel to the end surface (1₀₁) of this raised region (1₀) and down to the first etching stop layer in depth (t), and divides the raised region (1₀) into two parts (1₀₂, 1₀₃) which are isolated from one another.

4. Method according to one of the preceding claims, in which case the layers (23, 41, 42) which are located above the wave-conducting layer (22) are removed in the fourth layer stack (2₁), and at least one rib (22₁) is produced in the exposed surface (231) of the wave-conducting layer (22).

5. Method according to one of the preceding claims, in which case a laser-active layer (1₂) is produced whose quantum-well layers (11) and barrier layers (12) are arranged at least between two layers (100, 101) composed of a quaternary material having a gap wavelength which is less than that of the quantum-well layers (11).

6. Method according to one of the preceding claims, in which case a second layer stack (1₃) is produced on the laser-active layer (1₂), in which second layer stack (1₃) a further layer composed of p-doped InP or ternary material is arranged on the layer (15), which is arranged on the layer (14) composed of p-doped quaternary material and is itself composed of p-doped InP or ternary material, the surface of which further layer which faces away from the laser-active layer (1₂) forming the surface (16) of the second layer stack (1₃).

7. Arrangement comprising an MCRW-DFB high-temperature laser diode (1) and an optical waveguide (2) which is optically coupled to the laser diode (1), in which case,
on the surface of a substrate (30) composed of n⁺-doped InP
- a buffer layer (301) composed of n-doped InP, and on the buffer layer (301)
- a first etching stop layer (302) composed of n-doped quaternary material are formed,
on the first etching stop layer (302),
- a raised first layer sequence provided for the laser diode (1) and a second layer sequence provided for the waveguide (2) are formed and are arranged alongside one another, in which case
the first layer sequence comprises at least
- a layer (10) composed of n-doped InP
- a laser-active layer (1₂) arranged on this layer (10) and composed of two or more compressively stressed quantum-well layers (11) composed of a quaternary material, and composed of one or more barrier layers (12) located between the quantum-well layers (11) and composed of a quaternary material,
- a layer (13) arranged on the laser-active layer (1₂) and composed of p-doped InP,
- a layer (14) arranged on this layer (13) and composed of p-doped quaternary material,
- a layer (15) arranged on this layer (14) and composed of p-doped InP or ternary material having a surface (16) facing away from the laser-active layer (1₂), in which an optical grating (1₄) in the form of a relief is formed,
- a layer (17) covering the grating (1₄) and composed of p-doped InP,
- a second etching stop layer (18) arranged on this layer (17) and composed of p-doped quaternary material, and
- a layer (19) arranged on this layer (18) and composed of p-doped InP, and
the second layer sequence comprises
- a first and a second optical covering layer (21, 23) composed of InP, as well as
- a wave-conducting layer (22) located between these covering layers (21, 23) and composed of quaternary material, in which case
- the laser-active layer (1₂) and the wave-conducting layer (22) are located at the same level (h) with respect to the first etching stop layer (302) and butt against one another in mutually opposite end surfaces (1₀₁, 22₁) which are at an angle (α) to the first etching stop layer (302), and in which case
- a layer (41) composed of p-doped InP and a contact layer (42) arranged on this layer (41) and composed of p-doped InGaAs are formed on the two raised layer sequences, for the fitting of an electrical contact (4).

8. Arrangement according to Claim 7, in which case two depressions (61, 62) are formed in the region of the first layer sequence, which depressions (61, 62) extend down to the second etching stop layer (18) in depth (t), are separated from one another by a rib (1₀₀), which comprises layers (19, 41, 41) remaining between the depressions (61, 62) above the second etching stop layer (18) and has an axis (1₁₀) essentially at right angles to the end surface (1₀₁) of the laser-active layer (1₂), and which depressions (61, 62) extend into the vicinity of this end surface (1₀₁).

9. Arrangement according to Claim 7 or 8, in which case an isolating trench (63) is produced in the region of the first layer sequence, which isolating trench (63) extends essentially parallel to the end surface (1₁₀) of the laser-active layer (1₂) and down to the first etching stop layer in depth (T), and divides the first layer sequence and the other layers (41, 42) located on it into two parts (1₀₂, 1₀₃) which are isolated from one another.

10. Arrangement according to one of Claims 7 to 9, in which case the layers (23, 41, 42) located above the wave-conducting layer (22) are removed in the fourth layer stack (2₁), and at least one rib (22₁) is formed in the exposed surface (231) of the wave-conducting layer (22).

11. Arrangement according to one of Claims 7 to 10, in which case the quantum-well layers (11) and barrier layers (12) of the laser-active layer (1₂) are arranged at least between two layers (100, 101) composed of a quaternary material having a gap wavelength which is less than that of the quantum-well layers (11).

12. Arrangement according to one of Claims 7 to 11, in which case a further layer composed of p-doped InP or ternary material is formed in the first layer sequence on the layer (15) which is arranged on the layer (14) composed of p-doped quaternary material above the laser-active layer (1₂) and is composed of p-doped InP or ternary material, which further layer has a surface (16) which faces away from the laser-active layer (1₂) and in which the optical grating (1₄) in the form of the relief is formed.

## Revendications

1. Procédé pour la fabrication d'un dispositif constitué d'une diode laser (1) DFB-MCRW à haute température et d'un guide d'ondes (2) optique couplé à la diode laser (1), dans lequel
sur la surface d'un substrat (30) en InP à dopage n+,
lors d'une première étape d'épitaxie, on produit :
- une couche tampon (301) en InP à dopage n, sur celle-ci
- une première couche d'arrêt de gravure (302) en un matériau quaternaire, sur celle-ci
- un premier empilement de couches (1₁), qui est constitué d'au moins une couche (10) en InP à dopage n,
- sur le premier empilement de couches (1₁), une couche laser active (1₂) qui est constituée de deux ou plusieurs couches de puits quantiques (11) contraintes par compression et en un matériau quaternaire et d'une ou plusieurs couches barrières (12) en un matériau quaternaire et situées entre les couches de puits quantiques (11),
- sur la couche laser active (1₂), un deuxième empilement de couches (1₃), qui est constitué au moins d'une couche (13) en InP à dopage p disposée sur la couche laser active (1₁), d'une couche (14) en un matériau quaternaire à dopage p et disposée sur cette couche (13) et d'une couche (15) en InP à dopage p et disposée sur cette couche (14), et qui comporte une surface (16) à l'opposé de la couche laser active (1₂),
- dans la surface (16) du deuxième empilement de couches (1₃) un réseau optique (1₄) sous forme de relief,
lors d'une deuxième étape d'épitaxie :
- sur la surface (16), contenant le réseau (1₄), du deuxième empilement de couches (1₃), on produit un troisième empilement de couches (1₅) qui est constitué d'une couche (17) en InP à dopage p ou en un matériau ternaire et recouvrant le réseau (1₄), d'une deuxième couche d'arrêt de gravure (18) en un matériau quaternaire à dopage p et disposée sur cette couche (17) et d'une couche (19) en InP à dopage p et disposée sur cette couche (18),
- on élimine par endroits le deuxième empilement de couches (1₃), la couche laser active (1₂) et le premier empilement de couches (1₁) jusqu'à la première couche d'arrêt de gravure (302) de telle sorte qu'il reste sur cette couche d'arrêt de gravure (302) une zone en relief (1₀), qui est constituée du premier empilement de couches (1₁), de la couche laser active (1₂) et du deuxième empilement de couches (1₃) et qui a une surface frontale (1₀₁) faisant un angle (α) avec la première couche d'arrêt de gravure (302), et qu'il reste libre à côté de cette zone en relief (1₀) une zone (31₁), s'arrêtant à la surface frontale (10₁) de cette zone en relief (1₀), de la première couche d'arrêt de gravure (302),
lors d'une troisième étape d'épitaxie :
- on produit de manière sélective sur la zone libre (31₁) de la première couche d'arrêt de gravure (302), mais pas sur la zone en relief (1₀), un quatrième empilement de couches (2₁), qui définit le guide d'ondes (2) et qui est constitué d'une première et d'une deuxième couche latérale optique (21, 23) en InP ainsi que d'une couche (22) en un matériau quaternaire formant guide d'ondes et située entre ces deux couches enveloppantes (21, 23), la couche formant guide d'ondes (22) se trouvant par rapport à la première couche d'arrêt de gravure (302) à la hauteur (h) de la couche laser active (1₂) et comportant une surface frontale (22₁) qui fait face à la surface frontale (1₀₁) de la zone en relief (1₀),
et lors d'une quatrième étape d'épitaxie :
- on produit sur la zone en relief (1₀) et sur le quatrième empilement de couches (2₁) un cinquième empilement de couches (4₁), qui est constitué d'une couche (41) en InP à dopage p et d'une couche de contact (42) en InGaAs à dopage p disposée sur cette couche (41) pour pouvoir placer un contact électrique (4).

2. Procédé selon la revendication 1, dans lequel on produit dans la zone restant en relief (1₀) deux creux (61, 62) qui s'étendent à la profondeur (t) jusqu'à la deuxième couche d'arrêt de gravure (18), qui sont séparés par une nervure (1₀₀), formée de couches (19, 41, 42) de la zone en relief (1₀) restées debout entre les creux (61, 62) au-dessus de la deuxième couche d'arrêt de gravure (18) et ayant un axe longitudinal (1₁₀) globalement perpendiculaire à la surface frontale (1₀₁) de la zone en relief (1₀), et qui s'étendent jusqu'à proximité de cette surface frontale (1₀₁).

3. Procédé selon la revendication 1 ou 2, dans lequel on produit dans la zone restant en relief (1₀) un sillon de séparation (63) qui s'étend sensiblement parallèlement à la surface frontale (1₀₁) de la zone en relief (1₀) et à la profondeur (T) jusqu'à la première couche d'arrêt de gravure et qui divise la zone en relief (1₀) en deux parties (1₀₂, 1₀₃) séparées l'une de l'autre.

4. Procédé selon l'une des revendications précédentes, dans lequel on élimine dans le quatrième empilement de couches (2₁) les couches (23, 41, 42) se trouvant au-dessus de la couche formant guide d'ondes (22) et on produit dans la surface mise à nu (231) de la couche formant guide d'ondes (22) au moins une nervure (22₁).

5. Procédé selon l'une des revendications précédentes, dans lequel on produit une couche laser active (1₂) dont les couches de puits quantiques (11) et les couches barrières (12) sont disposées au moins entre deux couches (100, 101) en un matériau quaternaire ayant une longueur d'onde de bande interdite inférieure à celle des couches de puits quantiques (11).

6. Procédé selon l'une des revendications précédentes, dans lequel on produit sur la couche laser active (1₂) un deuxième empilement de couches (1₃) comme il est prévu, sur la couche (15) en InP à dopage p ou en un matériau ternaire et disposée sur la couche (1₄) en un matériau quaternaire à dopage p, une autre couche en InP. à dopage p ou en un matériau ternaire dont la surface qui est à l'opposé de la couche laser active (1₂) forme la surface (16) du deuxième empilement de couches (1₃).

7. Dispositif composé d'une diode laser (1) DFB-MCRW à haute température et d'un guide d'ondes (2) optique couplé optiquement à la diode laser (1),
dans lequel il est formé sur la surface d'un substrat (30) en InP à dopage n⁺
- une couche tampon (301) en InP à dopage n et sur la couche tampon (301)
- une première couche d'arrêt de gravure (302) en un matériau quaternaire à dopage n,
sur la première couche d'arrêt de gravure (302)
- une première succession de couches en relief prévue pour la diode laser (1) et une deuxième succession de couches prévue pour le guide d'ondes (2), lesquelles successions de couches sont disposées l'une à côté de l'autre,
la première succession de couches étant constituée au moins
- d'une couche (10) en InP à dopage n,
- d'une couche laser active (1₂) agencée sur cette couche (1₀) et composée de deux ou plusieurs couches de puits quantiques (11) contraintes par compression et en un matériau quaternaire et d'une ou plusieurs couches barrières (12) en un matériau quaternaire et situées entre les couches de puits quantiques (11),
- d'une couche (13) en InP à dopage p et disposée sur la couche laser active (1₂),
- d'une couche (14) en un matériau quaternaire à dopage p et disposée sur cette couche (13),
- d'une couche (15) en InP à dopage p ou en un matériau ternaire, disposée sur cette couche (14) et ayant une surface (16) qui est à l'opposé de la couche laser active (1₂) et dans laquelle un réseau optique (1₄) est produit sous forme de relief,
- d'une couche (17) en InP à dopage p et recouvrant le réseau (1₄),
- d'une deuxième couche d'arrêt de gravure (18) en un matériau quaternaire à dopage p et disposée sur cette couche (17) et
- d'une couche (19) en InP à dopage p et disposée sur cette couche (18), et
la deuxième succession de couches étant constituée
- d'une première et d'une deuxième couche latérale (21, 23) en InP,
- d'une couche formant guide d'ondes (22) en un matériau quaternaire et située entre ces couches enveloppantes (21, 23),
- la couche laser active (1₂) et la couche formant guide d'ondes (22) se trouvant à la même hauteur (h) par rapport à la première couche d'arrêt de gravure (302) et étant adjacentes par des surfaces frontales (1₀₁, 22₁) qui se font face et qui font un angle (α) avec la première couche d'arrêt de gravure (302), et
- une couche (41) en InP à dopage p et une couche de contact (42) en InGaAs à dopage p et disposée sur cette couche (41) pour pouvoir placer un contact électrique (4) étant produites sur les deux successions de couches en relief.

8. Dispositif selon la revendication 7, dans lequel, dans la zone de la première succession de couches, il est produit deux creux (61, 62) qui s'étendent à la profondeur (t) jusqu'à la deuxième couche d'arrêt de gravure (18), qui sont séparés par une nervure (1₀₀), formée de couches (19, 41, 41) restées entre les creux (61, 62) au-dessus de la deuxième couche d'arrêt de gravure (18) et ayant un axe (1₁₀) sensiblement perpendiculaire à la surface frontale (1₀₁) de la couche laser active (1₂), et qui s'étendent jusqu'à proximité de cette surface frontale (1₀₁).

9. Dispositif selon la revendication 7 ou 8, dans lequel il est produit dans la zone de la première succession de couches un sillon de séparation (63) qui s'étend globalement parallèlement à la surface frontale (1₀₁) de la couche laser active (1₂) et à la profondeur (T) jusqu'à la première couche d'arrêt de gravure et qui divise la première succession de couches et les autres couches (41, 42) qui se trouvent dessus en deux parties (1₀₂, 1₀₃) séparées l'une de l'autre.

10. Dispositif selon l'une des revendications 7 à 9, dans lequel, dans le quatrième empilement de couches (2₁), les couches (23, 41, 42) se trouvant au-dessus de la couche formant guide d'ondes (22) sont éliminées et au moins une nervure (22₁) est produite dans la surface libérée (231) de la couche formant guide d'ondes (22).

11. Dispositif selon l'une des revendications 7 à 10, dans lequel les couches de puits quantiques (11) et les couches barrières (12) de la couche laser active (1₂) sont disposées au moins entre deux couches (100, 101) en un matériau quaternaire ayant une longueur d'onde de bande interdite inférieure à celle des couches de puits quantiques (11).

12. Dispositif selon l'une des revendications 7 à 11, dans lequel il est produit dans la première succession de couches, sur la couche (15) en InP à dopage p ou en un matériau ternaire et disposées sur la couche (14) en un matériau quaternaire à dopage p au-dessus de la couche laser active (1₂), une autre couche en InP à dopage p ou en un matériau ternaire et comportant une surface (16) qui est à l'opposé de la couche laser active (1₂) et dans laquelle le réseau optique (14) est produit sous forme du relief.
